Europäisches Patentamt

European Patent Office

Office européen des brevets

(19)

(11) **EP 1 223 675 A1**

(12) # DEMANDE DE BREVET EUROPEEN

(43) Date de publication:
**17.07.2002 Bulletin 2002/29**

(51) Int Cl.⁷: **H03J 7/02**

(21) Numéro de dépôt: **02290012.0**

(22) Date de dépôt: **04.01.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **05.01.2001 FR 0100142**

(71) Demandeur: **Thales**
**75008 Paris (FR)**

(72) Inventeurs:
- **Clavel, Yannick, c/o Thales, Intellectual Property 94117 Arcueil Cédex (FR)**
- **Renard, Alain, c/o Thales, Intellectual Property 94117 Arcueil Cédex (FR)**

(54) **Procédé et dispositif pour compenser des erreurs de mesures dues à une dérive d'une horloge de référence**

(57) Procédé et dispositif pour corriger les erreurs de mesure de paramètres temporels t et/ou fréquentiels F dans un système comportant une base de temps local émettant une référence temporelle tr susceptible de varier sous l'effet d'un phénomène extérieur. Le procédé comporte au moins les étapes suivantes :

- mesurer au moins un paramètre extérieur tel que la température et/ou l'inertie ou la variation d'inertie du système,

- à partir d'un modèle reliant la valeur de la dérive en fréquence $\Delta E_{stimée}$ à la température et/ou à la variation d'inertie du système, déterminer la valeur corrigée des erreurs de mesure fréquentielle et/ou temporelle.

Application pour corriger des erreurs de mesure dans un système GPS ou GLONASS.

FIG.1

EP 1 223 675 A1

## Description

L'invention concerne un procédé et un dispositif permettant notamment de corriger les erreurs de mesure induites par une dérive d'une base de temps locale, la dérive résultant notamment de la dynamique opérationnelle.

Elle s'applique, par exemple, pour corriger des erreurs introduites par la dérive d'un oscillateur local, tel qu'une horloge de référence embarquée sur un mobile.

Elle est appliquée notamment pour corriger les erreurs de mesure dans des récepteurs GPS embarqués dans des mobiles ou des dispositifs soumis à une accélération importante.

Elle intéresse aussi tous les récepteurs de positionnement utilisant une base de temps locale précise ou, de manière plus générale, tout système de navigation incluant un récepteur de positionnement.

Elle s'applique encore, dans tous les systèmes qui requièrent la connaissance et l'entretien d'une base de temps locale précise et susceptible d'être affectée par la dynamique opérationnelle du dispositif auquel elle est associée.

L'un des systèmes de positionnement utilisé est le système GPS (Global Position System). Un tel système utilise une constellation de satellites qui tournent autour de la terre sur des orbites très précisément déterminées. On peut donc connaître à tout instant la position d'un satellite quelconque. Les satellites émettent des signaux radiofréquence contenant des données de navigation et des codes qui permettent d'identifier chaque satellite. Ces codes modulent en phase une fréquence porteuse, la modulation étant par exemple de type BPSK. Un récepteur GPS, au sol ou sur un véhicule terrestre, aérien ou maritime, peut recevoir les signaux de plusieurs satellites simultanément, calculer précisément sa distance à chacun des satellites et en déduire sa position précise en latitude, longitude et altitude, dans un repère terrestre. Il peut aussi déterminer la date et l'heure précise de la réception dans le repère temporel du système GPS. Il peut enfin en déduire, par des mesures Doppler, son propre vecteur vitesse dans le repère terrestre, dans le cas par exemple d'un récepteur monté sur un véhicule mobile. Les signaux radioélectriques GPS ont un spectre constitué d'une bande de 2 MHz centrée sur la fréquence $L_1$ = 1575 GHz, fréquence porteuse, respectivement la fréquence $L_2$ = 1273 GHz. Ces deux fréquences sont connues du domaine du GPS.

Différents modes de mise en oeuvre d'un tel système sont décrits par exemple dans les brevets FR 2.742.612 et FR 2.739.938 du demandeur. Seules les données nécessaires à la compréhension de l'objet de l'invention sont reprises ci-après.

La distance entre un satellite et le récepteur est déterminée par mesure de la durée de propagation, à la vitesse de la lumière, du signal radio entre un satellite et la terre. Elle est donc déterminée, en particulier, par une mesure de l'écart temporel entre l'instant d'émission par le satellite d'un bit caractéristique (bit « epoch ») du code pseudo-aléatoire et l'instant de réception, par le récepteur de ce bit caractéristique.

Les distances du récepteur à trois satellites différents permettent de déterminer la position du récepteur dans un repère terrestre fixe, dès lors que le récepteur connaît la position des satellites dans ce repère à l'instant de la mesure. Un quatrième satellite est généralement utilisé pour éliminer l'écart entre l'horloge du récepteur et l'horloge du système GPS. La position des satellites à chaque instant définie par référence à une horloge générale de système et les données de navigation émises permettent au récepteur de connaître cette référence temporelle.

L'utilisation d'une horloge locale stable sur la durée d'observation du signal nécessaire à son filtrage est donc nécessaire pour déterminer de manière précise les paramètres de position tels que la vitesse et le temps. Toutefois, des phénomènes extérieurs, par exemple la variation soudaine de la température, les chocs mécaniques ou encore la dynamique du système peuvent dégrader la précision de l'horloge du récepteur GPS.

L'art antérieur divulgue plusieurs méthodes pour corriger cette variation dont certaines sont décrites ci-après.

### Compensation en température

Une première approche consiste à effectuer une compensation en température.

Pour cela, le quartz est régulé en température en le thermostatant, méthode OCXO (abréviation anglo-saxonne Oven Controled compensated crystal oscillator). Cette méthode permet d'éliminer les dérives en température et en fréquence. Elle présente toutefois les inconvénients suivants :

- Consommer de l'électricité,
- La nécessité d'un temps de chauffe pour atteindre la température requise,
- une intégration peu évidente, et
- une fiabilité discutable.

Le quartz peut aussi être compensé en température, méthode connue sous l'abréviation TCXO (en anglo-saxon temperature compensated crystal oscillator). Elle met en oeuvre une correction analogique câblée lors de la fabrication, incluant par exemple une thermistance. Cette méthode présente toutefois comme inconvénient de présenter une dérive du quartz en fonction de la température, évoluant en fonction du vieillissement et des contraintes, et d'utiliser un modèle de compensation peu précis.

La méthode connue sous l'abréviation DTCXO (Digital temperature compensated crystal oscillator) est similaire au procédé TCXO, mais utilise une correction numérique. Bien que le modèle de compensation utilisé soit plus précis, elle présente toujours l'inconvénient de la dérive du quartz en fonction de la température, qui évolue avec le vieillissement et les contraintes.

**Compensation en dynamique**

Une deuxième approche consiste à réaliser une compensation dynamique, telle que celle décrite dans le brevet US 6,067,503.

Le procédé décrit dans ce brevet met en oeuvre une mesure de la dérivée de la variation de fréquence due à la dynamique. Cette dérivée est calculée à partir de la différence de la fréquence VCO et de la fréquence quartz durant la constante de temps du VCO. Or étant de conception analogique la constante de temps le gain du VCO, les offsets évolue avec le temps (vieillissement), la température, etc. et les mesures deviennent peu précises car ces évolutions ne sont pas corrigées. Une telle méthode présente l'avantage d'être de faible coût mais aussi d'offrir de faibles performances.

L'objet de l'invention repose sur une nouvelle approche consistant à utiliser un modèle pour notamment corriger les erreurs de mesure.

L'invention concerne un procédé pour corriger les erreurs de mesure de paramètres temporels t et/ou fréquentiels F dans un système comportant une base de temps local émettant une référence temporelle tr susceptible de varier sous l'effet d'un phénomène extérieur caractérisé en ce qu'il comporte au moins les étapes suivantes :

- mesurer au moins un paramètre extérieur tel que la température et/ou l'inertie ou la variation d'inertie du système,
- à partir d'un modèle reliant la valeur de la dérive en fréquence $\Delta F_{estimée}$ à la température et/ou à la variation d'inertie du système, déterminer la valeur corrigée des erreurs de mesure fréquentielle et/ou temporelle.

Selon une variante de réalisation, il comporte une étape de correction des représentations locales des signaux temporel (code) et/ou fréquentiel (doppler) et une étape de comparaison de ces représentations locales aux signaux reçus afin de les asservir à ces derniers.

Le paramètre mesuré est par exemple la vitesse relative ou l'accélération d'un mobile par rapport au système et en ce que la valeur de la vitesse relative F est corrigée en tenant compte de la dérive en fréquence $\Delta F_{estimée}$ multipliée par la vitesse de la lumière.

Les représentations locales corrigées sont par exemple utilisées en fonctionnement nominal dit de poursuite des signaux et/ou dans la phase d'accrochage ou d'acquisition des signaux.

L'invention concerne aussi un dispositif pour corriger les erreurs de mesure de paramètres temporels et/ou fréquentiels dans un système comportant une base de temps local émettant une référence temporelle tr susceptible de varier sous l'effet d'un phénomène extérieur, tel que l'inertie ou la variation d'inertie du système, caractérisé en ce qu'il comporte au moins les éléments suivants :

- un modèle représentatif de la variation de la fréquence en fonction de la température et/ou d'un paramètre traduisant l'inertie ou la variation d'inertie du système,
- un dispositif permettant de déterminer la valeur de la température et/ou la valeur du paramètre représentatif de l'inertie ou de la variation d'inertie du système,
- des moyens pour obtenir la valeur de la dérive en fréquence $\Delta F_{estimée}$ à partir de l'inertie ou de la variation de l'inertie du système et du modèle,
- des moyens pour combiner la dérive en fréquence $\Delta F_{estimée}$ avec le modèle afin d'obtenir la valeur corrigée $\Delta t_{cor}$, $\Delta F_{cor}$ dudit paramètre temporel t, et/ou fréquentiel F

Il comporte aussi des moyens adaptés à déterminer des représentations locales des signaux temporel (code) et/ou fréquentiel (doppler) et comparer ces représentations locales aux signaux reçus afin de les asservir à ces derniers.

Le procédé et le dispositif selon l'invention peuvent être utilisés pour corriger des erreurs de mesure dans un système GPS ou GLONASS.

Le procédé et le dispositif selon l'invention offrent notamment les avantages suivants :

- offrir un traitement rapide des erreurs dynamiques et thermiques en utilisant un modèle direct de correction,
- offrir une correction plus précise grâce à l'adaptation en continu du modèle en utilisant les redondances des systèmes de mesure.
- En phase d'acquisition de réduire les plages de recherche et donc d'améliorer de manière significative les performances

D'autres caractéristiques et avantages de l'invention apparaîtront à la lecture de la description détaillée d'un mode de réalisation pris à titre d'exemple non limitatif et illustré par les dessins annexés où :

- la figure 1 représente un schéma de principe d'un récepteur selon l'invention,
- la figure 2 est un schéma détaillé de la figure 1, et
- la figure 3 une variante intégrant la correction en continu du modèle.

Afin de mieux comprendre le principe mis en oeuvre dans l'invention, la description, donnée à titre illustratif et nullement limitatif, concerne un récepteur GPS soumis à une dynamique opérationnelle, telle qu'une accélération, plus particulièrement dans le cas de signaux

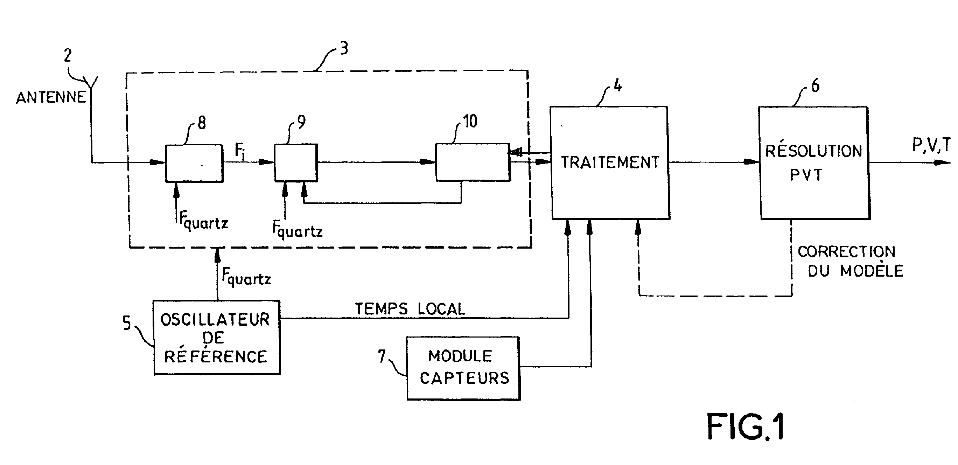

La figure 1 représente un exemple de synoptique fonctionnel du procédé de base selon l'invention, schématisant l'idée mise en oeuvre. Cette figure représente un récepteur 1 en liaison avec une antenne 2 adaptée à recevoir les signaux satellites par exemple des signaux dans la bande de fréquence $L_1$ et/ou $L_2$. Le récepteur comporte un premier bloc 3 adapté à transformer les signaux reçus en échantillons avant de les transmettre au bloc de traitement 4, un oscillateur de référence 5, tel qu'un quartz et un bloc de résolution 6 PVT connu de l'Homme du métier.

Le système selon l'invention comporte aussi un module de capteurs 7, pouvant être intégré dans le récepteur 1. Ce module, lorsqu'il est indépendant du récepteur comporte, par exemple, une centrale d'inertie délivrant les valeurs d'accélération selon trois axes Ax, Ay et Az et un capteur adapté à mesurer la température.

Les signaux GPS reçus par l'antenne 2 ont un spectre constitué d'une bande de 20 MHz centrée sur la fréquence $L_1$ = 1.575 GHz (fréquence porteuse), respectivement la fréquence $L_2$ = 1.273 GHz. Ils sont transmis à un premier circuit 8, pour être transposés à une fréquence intermédiaire Fi plus faible que la fréquence porteuse ($L_1$, $L_2$). La fréquence intermédiaire est par exemple égale à la fréquence de la porteuse diminuée de la fréquence du quartz multipliée par un coefficient, selon un procédé connu de l'Homme du métier. Ces signaux sont ensuite échantillonnés dans un circuit 9, à une fréquence d'échantillonnage correspondant à la fréquence synthétisée à partir de la fréquence $F_{quartz}$ issue du bloc 5.

Les échantillons sont ensuite transmis à un dispositif d'asservissement 10 qui délivre d'une part les temps reçus et le signal Doppler et d'autre part une commande NCO (Numerical controlled Oscillator) qui est renvoyée vers l'ASIC d'échantillonnage 9. Cet asservissement est réalisé par exemple par logiciel.

Dans le cas de signaux à spectre étalé, le dispositif d'asservissement de compose d'une synthèse de répliques locales des signaux à recevoir, de la génération de plusieurs répliques décalées, de corrélateurs (multiplications dans le cas d'un signal BPSK), de filtres passe-bas, de discriminateurs (DDL pour le code, PLL pour la porteuse), de filtres de boucle (asservissement) et d'un dispositif de mesure en temps (code) et Doppler (porteuse). Ces éléments sont biens connus de l'Homme du métier. Une partie des fonctions est généralement effectuée en matériel et une autre en logiciel.

Sans sortir du cadre de l'invention d'autres architectures sont possibles, de type FFT-produit- FFT inverse, etc.

Les différents traitements mis en oeuvre sont par exemple réalisés au moyen d'ASIC.

Les échantillons temporels reçus et le signal Doppler sont transmis au bloc de traitement 4 qui intègre un logiciel adapté, implanté dans un microprocesseur. Le bloc 4 de traitement est adapté notamment à mettre en oeuvre les étapes du procédé selon l'invention. En sortie de ce bloc de traitement, les corrections réalisées sont transmises soit au bloc de résolution PVT, soit au dispositif 10.

Ce bloc permet aussi d'exécuter l'algorithme de recherche du signal selon des méthodes connues de l'Homme du métier, par exemple, en scannant toutes les positions de code GPS dans chaque fenêtre Doppler jusqu'à l'acquisition totale par la réception de position.

En sortie de ce bloc de traitement 4, les mesures corrigées sont transmises au module de résolution PVT 6. Ce module a notamment pour fonction de déterminer la position, la vitesse du porteur ainsi que la valeur de l'erreur de l'horloge de référence locale. Ce type de module est connu de l'Homme du métier.

Les différents traitements réalisés dans les blocs 4, 6 et 10 peuvent être effectués par logiciel intégré dans un processeur unique ou plusieurs processeurs.

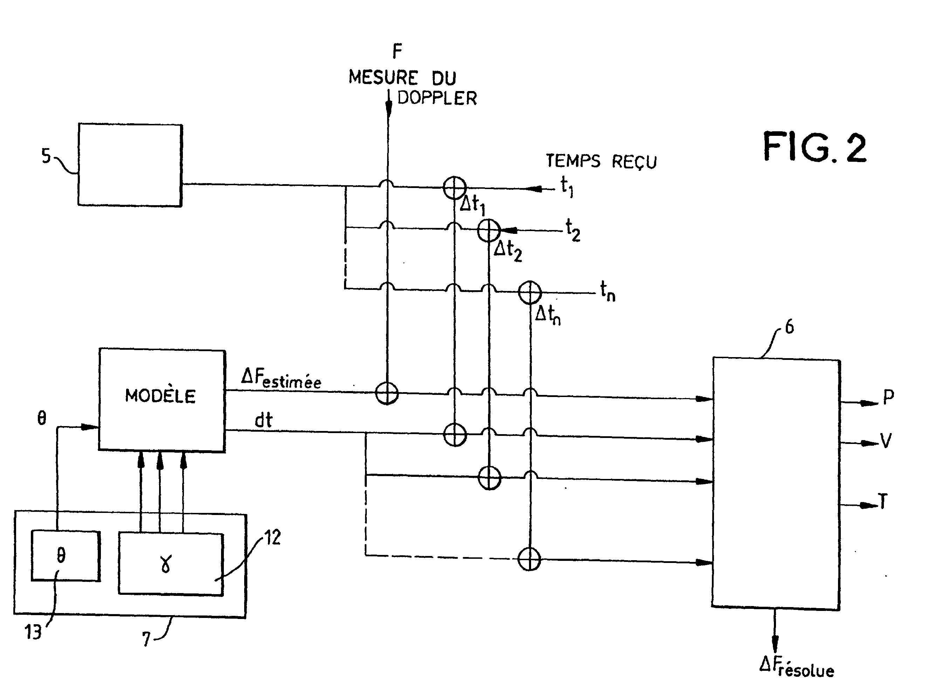

La figure 2 est donnée pour expliciter certaines des étapes exécutées par le procédé selon l'invention.

**Modèle utilisé**

Le procédé fait appel à un modèle de correction défini par exemple de la manière suivante.

Les variations des caractéristiques du quartz en fonction de la température et des variations d'accélération sont connues. La dérive en fréquence en fonction de la température peut être modélisée classiquement par la relation [1] :

$$\Delta F_\theta = a + b(\theta-\theta_0) + c(\theta-\theta_0)^2 + d(\theta-\theta_0)^3$$

où $\theta$ est une valeur de température donnée et $\theta_0$ la température de référence.

Le quartz étant soumis à différentes valeurs de température $\theta$, on en déduit les valeurs des coefficients a, b et c.

De manière similaire, en soumettant le quartz à différentes accélérations, on obtient les composantes de la dérive en fréquence exprimée selon les trois axes x,y,z selon la relation [2] :

$$\Delta F_{\gamma x} = \alpha_x \gamma_x$$

$$\Delta F_{\gamma y} = \alpha_y \gamma_y$$

$$\Delta F_{\gamma z} = \alpha_z \gamma_z$$

les coefficients $\alpha_x$, $\alpha_y$, $\alpha_z$ étant des constantes choisies en fonction des caractéristiques du quartz.

Les valeurs de la dérive en fréquence en fonction de la température et/ou de l'accélération sont utilisées pour construire un modèle de correction. Ce modèle se présente par exemple sous la forme d'une table donnant, pour une température donnée et/ou une accélération donnée, la valeur des composantes de la dérive en fréquence $\Delta F_\theta$ et $\Delta F_{\gamma x}$, $\Delta F_{\gamma y}$, $\Delta F_{\gamma z}$, à partir desquelles on déduit $\Delta F_{estimée}$.

A partir des valeurs estimées de dérive en fréquence, il est possible par intégration par exemple de déduire la valeur de dérive temporelle dt. Cette valeur temporelle dt permet de corriger les mesures temporelles.

## Utilisation du modèle pour corriger les erreurs de mesure fréquentielle et temporelle

Le procédé permet donc de corriger, en tenant compte du modèle préétabli et connaissant les valeurs de la température et/ou des composantes de l'accélération délivrées par le module de capteur, les valeurs mesurées de la fréquence Doppler et des mesures temporelles.

## Mesure Doppler

a) Pour la mesure Doppler F, correspondant à la vitesse relative entre le récepteur et le satellite le microprocesseur tient compte de la valeur de l'accélération $\gamma$ mesurée par le module de capteurs pour déterminer à l'aide du modèle de correction précitée la valeur $\Delta F_{estimée}$ à soustraire de la vitesse relative mesurée. Préalablement à la soustraction cette valeur $\Delta F_{estimée}$ est multipliée par la vitesse de la lumière c exprimée en m/s. De façon complémentaire, le microprocesseur peut aussi tenir compte de la valeur de la température mesurée pour déterminer, dans le modèle de correction, la valeur $\Delta F_{estimée}$.

## Mesures temporelles

b) Pour les mesures de temps ti, correspondant au temps reçu ti,

- Le microprocesseur calcule dans un premier temps, la valeur de l'écart temporel $\Delta ti$ ou pseudo-distance, en soustrayant de la valeur de temps ti, la valeur de temps local tr,
- Puis connaissant, les valeurs des coefficients d'accélération $\gamma_x$, $\gamma_y$, $\gamma_z$ données par le module de capteurs, il détermine la valeur de dérive temporelle $\Delta t$ à partir du modèle précité, pour la soustraire de chaque valeur $\Delta ti$.

- Selon un autre mode de mise en oeuvre, la valeur de la dérive temporelle est déterminée en prenant aussi en compte la valeur de la température.

Les différentes valeurs mesurées et corrigées, $\Delta F_{cor}$, $\Delta t_{cor}$ sont transmises au module de résolution PVT 6 qui en déduit la valeur de position P, la valeur de vitesse V du satellite ainsi que la valeur de fréquence résolue $\Delta F_{résolue}$ correspondant à l'erreur de fréquence.

Sans sortir du cadre de l'invention, l'erreur de fréquence estimée $\Delta F_{estimée}$ peut aussi être obtenue non plus en utilisant un modèle préétabli et mémorisé, mais en utilisant un modèle déterminé en temps réel par le microprocesseur. Dans ce cas, le microprocesseur est équipé d'un logiciel qui détermine les valeurs correspondantes des dérives en fréquence et en température en fonction des mesures de la température et/ou de l'accélération. Ces valeurs sont ensuite utilisées comme il a été décrit pour le modèle se présentant sous la forme d'une table de données.

## Correction dans le cadre des signaux à spectre étalé

Pour la réception de signaux sans étalement de spectre, les mesures de temps ( $t_1, t_2 ... t_n$ ) et /ou de doppler sont extraits directement du signal, particulièrement lorsque les signaux sont puissants.

Dans le cas de la réception de signaux en spectre étalé, il est nécessaire d'extraire le signal par un filtrage adapté, généralement par corrélation avec une réplique locale (image locale, représentation locale) puis filtrage (généralement dans le bloc 10), afin de pouvoir extraire les mesures de temps et de doppler en présence du bruit particulièrement pour les signaux faibles ou en présence de perturbateurs.

Dans ce cas afin d'accroître la sensibilité de mesure il est utile de pouvoir filtrer sur le temps le plus grand possible, ceci n'est possible que si l'image locale "suit " bien le signal utile.

L'image locale est généré à partir de l'oscillateur local de référence. Or en présence de fluctuation de cette référence en fonction de l'environnement, cette image est modulée donc imparfaite et dégrade les performances. Dans certains cas il est possible qu'elle n'assure même plus sa fonction (perte totale du signal et donc des mesures).

L'invention consiste à utiliser le module de capteur pour mesurer un ou plusieurs paramètres de l'environnement (température, accélération, etc), puis à utiliser le modèle prédit (construit à partir de l'équation [1] et/ou recalé (modèle corrigé) pour corriger l'image locale afin de l'améliorer malgré un environnement perturbé. Ceci est réalisé par exemple par la transmission du bloc 4 de corrections qu'il a calculé au bloc 10 qui générant l'image locale applique les dites corrections. Le procédé comporte aussi une étape de comparaison de ces représentations locales avec les signaux reçus afin d'assurer leur coïncidence par asservissement.

Les corrections à appliquer à l'image locale doivent en général être rafraîchies plus rapidement que les corrections effectuées sur les mesures de temps et de doppler. Elles peuvent être obtenues par un calcul plus rapide et/ou une interpolation.

Dans le cas d'un récepteur avec plusieurs canaux, donc plusieurs images, les corrections à appliquer sont communes à tous les canaux en les exprimant en temps et en variation de temps, ce qui permet de simplifier les calculs.

Cette invention peut être utilisée avec et sans la correction des mesures déjà décrite, en cas d'application des deux types de corrections une partie importante des calculs peut être commun.

**Correction du modèle**

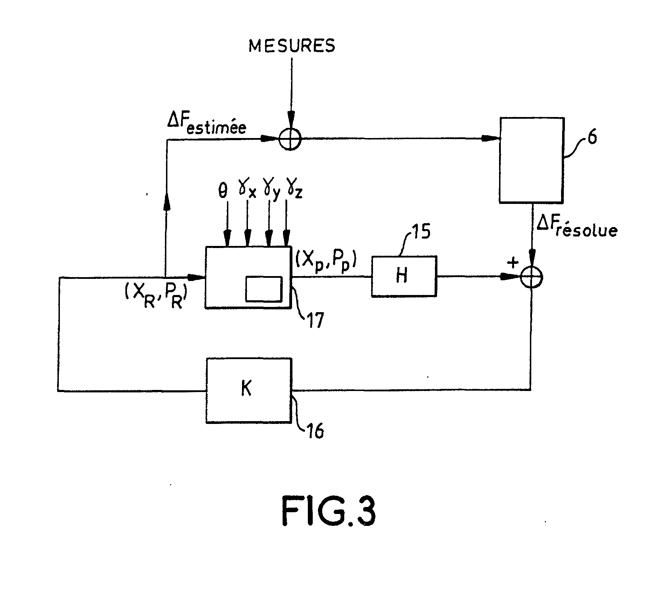

Selon une variante de réalisation décrite à la figure 3, la valeur de la fréquence résolue $\Delta F_{résolue}$ issue du module PVT est utilisée pour mettre à jour le modèle utilisé.

Lorsque le modèle de correction se présente sous la forme d'une table ou d'une base de données préétablie, il est par exemple intégré dans une mémoire reprogrammable, non volatile (non représentée sur la figure pour des raisons de simplification). L'utilisation d'une telle mémoire permet notamment de récupérer le dernier modèle mis à jour par l'équipement avant la mise hors tension. Il peut aussi être déterminé en cours de fonctionnement par logiciel intégré dans le microprocesseur.

Pour cela, le procédé consiste par exemple à envoyer la valeur de fréquence résolue $\Delta F_{résolue}$ à un filtre de Kalman, implémenté dans le module permettant de déterminer la dérive en fréquence et la dérive temporelle tel que décrit à la figure 3.

La valeur de fréquence résolue $\Delta F_{résolue}$ est sommée au vecteur d'état à une dimension issu de la matrice d'observation 30, le vecteur d'état résultant est ensuite soumis à une matrice de gain 31, adaptatif permettant une pondération optimale pour ce vecteur d'état. A l'issue de cette matrice 31, le vecteur d'état a pour coordonnées la valeur de dérive en fréquence estimée ainsi que les valeurs des composantes de l'accélération par exemple. La coordonnée $\Delta F$ de ce vecteur est utilisée pour corriger la valeur de Doppler mesurée selon un schéma similaire à celui décrit à la figure 2 et aussi à déterminer par intégration la valeur de la dérive temporelle dt de façon à corriger les pseudo-distances $\Delta ti$.

Le vecteur d'état recalé Xr est transformé en vecteur d'état propagé Xp à l'aide de la matrice de propagation 32 tenant compte des valeurs de température et/ou d'accélérations mesurées par le module de capteurs. Il est associé à une matrice de covariance Pp permettant d'estimer la confiance à accorder à ces mesures. Le vecteur d'état propagé est ensuite transformé par la matrice d'observation avant d'être soustrait à la mesure.

Par exemple :
Le vecteur X est un vecteur de coordonnées ($\Delta F$, $\alpha_x$, $\alpha_y$, $\alpha_z$) où $\alpha_x$, $\alpha_y$, $\alpha_z$ sont définis comme suit :

$$\Delta F_x = \alpha_x \gamma_x$$

$$\Delta F_y = \alpha_y \gamma_y$$

$$\Delta F_z = \alpha_z \gamma_z$$

■ F ou 32 est une matrice de propagation, décrivant un modèle d'évolution des composantes du vecteur d'état X,

■ H ou 30 est la matrice d'observation par exemple [ 1 0 0 0]

■ K ou 31 est la matrice de gain déterminée classiquement à partir des autres matrices.

Selon une variante de mise en oeuvre, le procédé est utilisé pour réduire les plages de recherche de la phase acquisition du signal. Durant cette phase généralement après la mise sous tension il est nécessaire d'acquérir (se synchroniser) sur les signaux reçus par une recherche " temps fréquence". L'invention permet d'obtenir une meilleur estimée de l'erreur de la référence locale et donc de réduire l'incertitude en fréquence des signaux reçus (il ne reste plus que la vitesse du porteur), la recherche se réduisant essentiellement alors au "temps".

**Revendications**

**1.** Procédé pour corriger les erreurs de mesure de paramètres temporels t et/ou fréquentiels F dans un système comportant une base de temps local émettant une référence temporelle tr susceptible de varier sous l'effet d'un phénomène extérieur **caractérisé en ce qu'**il comporte au moins les étapes suivantes :

- mesurer au moins un paramètre extérieur tel que la température et/ou l'inertie ou la variation d'inertie du système,
- à partir d'un modèle reliant la valeur de la dérive en fréquence $\Delta F_{estimée}$ à la température et/ou à la variation d'inertie du système, déterminer la valeur corrigée des erreurs de mesure fréquentielle et/ou temporelle.

**2.** Procédé selon la revendication 1 **caractérisé en ce qu'**il comporte une étape de correction des représentations locales des signaux temporel (code) et/ou fréquentiel (doppler) et une étape de comparaison de ces représentations locales aux signaux reçus afin de les asservir à ces derniers.

3. Procédé selon la revendication 1 **caractérisé en ce que** le paramètre mesuré est la vitesse relative ou l'accélération d'un mobile par rapport au système et **en ce que** la valeur de la vitesse relative F est corrigée en tenant compte de la dérive en fréquence $\Delta F_{estimée}$ multipliée par la vitesse de la lumière.

4. Procédé selon l'une des revendications 1 à 3 **caractérisé en ce que** la valeur de dérive en fréquence est déterminée à partir d'une base de données préétablie tenant compte des valeurs de température et/ou des valeurs d'accélération et du comportement de la base de temps local en fonction desdites valeurs.

5. Procédé selon l'une des revendications 1 à 3 **caractérisé en ce que** la valeur de dérive en fréquence $\Delta F_{estimée}$ est obtenue en déterminant en temps réel ladite valeur en tenant compte d'un modèle de comportement de l'horloge de base et des valeurs de température et/ou d'accélérations mesurées en temps réel.

6. Procédé selon l'une des revendications 1 à 5 **caractérisé en ce que** les valeurs de mesure temporelles et/ou fréquentielles corrigées sont transmises à un modèle de résolution PVT pour en déduire au moins la valeur de fréquence résolue et **en ce que** la valeur de fréquence résolue $\Delta F_{estimée}$ est utilisée pour mettre à jour la base de données ou déterminer $\Delta F_{estimée}$.

7. Procédé selon la revendication 6 **caractérisé en ce qu'**il utilise un filtre de Kalman pour déterminer en temps réel la valeur de dérive en fréquence.

8. Procédé selon la revendication 2 **caractérisé en ce que** les représentations locales corrigées sont utilisées en fonctionnement nominal dit de poursuite des signaux et/ou dans la phase d'accrochage ou d'acquisition des signaux.

9. Utilisation du procédé selon l'une des revendications 1 à 8 pour corriger les mesures de temps dans des systèmes GPS ou GLONASS soumis à une accélération.

10. Dispositif pour corriger les erreurs de mesure de paramètres temporels et/ou fréquentiels dans un système comportant une base de temps local émettant une référence temporelle tr susceptible de varier sous l'effet d'un phénomène extérieur, tel que l'inertie ou la variation d'inertie du système, **caractérisé en ce qu'**il comporte au moins les éléments suivants :

- un modèle représentatif de la variation de la fréquence en fonction de la température et/ou d'un paramètre traduisant l'inertie ou la variation d'inertie du système,
- un dispositif permettant de déterminer la valeur de la température et/ou la valeur du paramètre représentatif de l'inertie ou de la variation d'inertie du système,
- des moyens pour obtenir la valeur de la dérive en fréquence $\Delta F_{estimée}$ à partir de l'inertie ou de la variation de l'inertie du système et du modèle,
- des moyens pour combiner la dérive en fréquence $\Delta F_{estimée}$ avec le modèle afin d'obtenir la valeur corrigée $\Delta t_{cor}$, $\Delta F_{cor}$ dudit paramètre temporel t, et/ou fréquentiel F

11. Dispositif selon la revendication 10 **caractérisé en ce qu'**il comporte des moyens adaptés à déterminer des représentations locales des signaux temporel (code) et/ou fréquentiel (doppler) et comparer ces représentations locales aux signaux reçus afin de les asservir à ces derniers.

12. Dispositif selon la revendication 10 **caractérisé en ce qu'**il comporte un capteur de mesure de l'accélération.

13. Dispositif selon l'une des revendications 10 à 12 **caractérisé en ce que** le modèle est une base de données préétablies en tenant compte du comportement de la base de temps local en fonction de la variation de température et/ou de l'accélération.

14. Dispositif selon l'une des revendications 10 à 12 **caractérisé en ce qu'**il comporte un processeur adapté pour déterminer le modèle de correction en temps réel.

15. Dispositif selon l'une des revendications 10 à 14 **caractérisé en ce qu'**il comporte un module permettant de déterminer la valeur de fréquence résolue et un dispositif, tel qu'un filtre de Kalman, pour corriger, à partir de la valeur de fréquence résolue, la valeur de fréquence estimée.

16. Utilisation du dispositif selon l'une des revendications 10 à 15 pour corriger des erreurs de mesure dans un système GPS ou GLONASS.

FIG.1

ANTENNE

2

3

8   $F_i$   9   10

$F_{quartz}$   $F_{quartz}$

TRAITEMENT   4

RÉSOLUTION PVT   6

P,V,T

$F_{quartz}$

5   OSCILLATEUR DE RÉFÉRENCE

TEMPS LOCAL

7   MODULE CAPTEURS

CORRECTION DU MODÈLE

EP 1 223 675 A1

8

FIG.2

F
MESURE DU
DOPPLER

TEMPS REÇU

$t_1$

$\Delta t_1$

$t_2$

$\Delta t_2$

$t_n$

$\Delta t_n$

5

MODÈLE

$\theta$

$\Delta F_{estimée}$

dt

$\theta$

$\gamma$

13

12

7

6

P

V

T

$\Delta F_{résolue}$

EP 1 223 675 A1

FIG.3

**EP 1 223 675 A1**

Office européen
des brevets

**RAPPORT DE RECHERCHE EUROPEENNE**

Numéro de la demande

EP 02 29 0012

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 742 908 A (DENT PAUL W) 21 avril 1998 (1998-04-21) | 1 | H03J7/02 |
| Y | * figures 1-4 * * colonne 1, ligne 45-70 * * colonne 2, ligne 1-65 * * colonne 6, ligne 25-70 * --- | 9 | |
| Y | US 6 067 503 A (YAKOS MICHAEL D) 23 mai 2000 (2000-05-23) | 9 | |
| A | * figure 1 * * colonne 3, ligne 1-70 * * colonne 4, ligne 1-70 * * colonne 5, ligne 25-70 * * colonne 6, ligne 20-50 * ----- | 2-8, 10-16 | |

|  | DOMAINES TECHNIQUES RECHERCHES (Int.Cl.7) |
|---|---|
|  | H03J G04G H04J H04B G01S G01C |

Le présent rapport a été établi pour toutes les revendications

| Lieu de la recherche | Date d'achèvement de la recherche | Examinateur |
|---|---|---|
| LA HAYE | 8 mai 2002 | Coffa, A |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
—————————————————————————————
& : membre de la même famille, document correspondant

EPO FORM 1503 03.82 (P04C02)

11

**ANNEXE AU RAPPORT DE RECHERCHE EUROPEENNE
RELATIF A LA DEMANDE DE BREVET EUROPEEN NO.**

EP 02 29 0012

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

08-05-2002

| Document brevet cité au rapport de recherche | | Date de publication | Membre(s) de la famille de brevet(s) | | Date de publication |
|---|---|---|---|---|---|
| US 5742908 | A | 21-04-1998 | AU | 693272 B2 | 25-06-1998 |
| | | | AU | 3729695 A | 29-03-1996 |
| | | | BR | 9506495 A | 07-10-1997 |
| | | | CA | 2174938 A1 | 21-03-1996 |
| | | | CN | 1135813 A | 13-11-1996 |
| | | | EP | 0728385 A1 | 28-08-1996 |
| | | | FI | 962027 A | 13-05-1996 |
| | | | JP | 9510067 T | 07-10-1997 |
| | | | WO | 9608882 A1 | 21-03-1996 |
| US 6067503 | A | 23-05-2000 | AUCUN | | |

EPO FORM P0460

Pour tout renseignement concernant cette annexe : voir Journal Officiel de l'Office européen des brevets, No.12/82